Europäisches Patentamt

European Patent Office

Office européen des brevets

(11) Veröffentlichungsnummer: **0 292 644**
**A1**

## EUROPÄISCHE PATENTANMELDUNG

(21) Anmeldenummer: 88102357.6

(22) Anmeldetag: 18.02.88

(51) Int. Cl.4: **B60K 31/04** , **G06F 11/22** ,
**G01R 31/28**

(30) Priorität: 21.05.87 DE 3717012

(43) Veröffentlichungstag der Anmeldung:
**30.11.88 Patentblatt 88/48**

(84) Benannte Vertragsstaaten:
**DE FR SE**

(71) Anmelder: **VDO Adolf Schindling AG**
**Gräfstrasse 103**
**D-6000 Frankfurt/Main(DE)**

(72) Erfinder: **Reisch, Wolfgang**
**Römerberg 5**
**D-6465 Biebergemünd 3(DE)**
Erfinder: **Ohm, Heinz-Friedrich**
**Franz-Seliger-Strasse 8**
**D-6108 Weiterstadt(DE)**
Erfinder: **Appel, Hans-Günter**
**Brahmstrasse 4**
**D-6232 Bad Soden(DE)**

(74) Vertreter: **Klein, Thomas, Dipl.-Ing. (FH)**
**Sodener Strasse 9 Postfach 6140**
**D-6231 Schwalbach a. Ts.(DE)**

(54) Verfahren zur Programmierung eines digitalen Steuergerätes.

(57) Bei einem Verfahren zur Programmierung eines
für ein Kraftfahrzeug vorgesehenen digitalen Steuergerätes, welches mit einer Diagnoseschnittstelle versehen ist, wird der Diagnoseschnittstelle ein Signal
zugeführt, welches eine Umschaltung von einem Betriebsmodus in einen Programmiermodus bewirkt.
Eine Eingabe von Signalen zur Programmierung erfolgt über Eingabe-Elemente, die an sich für Eingaben während des Betriebsmodus vorgesehen sind.

Fig. 1

EP 0 292 644 A1

## Verfahren zur Programmierung eines digitalen Steuergerätes

Die Erfindung betrifft ein Verfahren zur Programmierung eines für ein Kraftfahrzeug vorgesehenen digitalen Steuergerätes, welches mit einer Diagnoseschnittstelle versehen ist.

Bei digitalen Steuergeräten, welche für Kraftfahrzeuge vorgesehen sind, ist es häufig erforderlich, fahrzeugspezifische Daten einzugeben. So kann beispielsweise bei einem für verschiedene Fahrzeuge verwendbaren Geschwindigkeitsregler die Zuordnung der Motordrehzahl zur Frequenz der dem Regler zugeführten Drehzahlimpulse, welche bei dem individuellen Fahrzeug vorliegt, in dem Regler abgespeichert werden. Bei einem gleichen Regler ist es ferner vorteilhaft, eine höchstzulässige Drehzahl abzuspeichern, welche ebenfalls von der jeweiligen Motorbauform abhängig ist.

Zur Eingabe derartiger Daten - im folgenden Programmierung genannt - sind bei bekannten digitalen Steuergeräten besondere Peripherie-Anordnungen, wie beispielsweise Steckvorrichtungen und/oder Betätigungselemente vorgesehen, welche einen zusätzlichen technischen Aufwand und entsprechende Kosten verursachen.

Aufgabe der vorliegenden Erfindung ist es, ein Verfahren zur Programmierung eines für ein Kraftfahrzeug vorgesehenen digitalen Steuergerätes anzugeben, bei welchem praktisch kein zusätzlicher Aufwand erforderlich ist.

Das erfindungsgemäße Verfahren ist dadurch gekennzeichnet, daß der Diagnoseschnittstelle ein Signal zugeführt wird, welches eine Umschaltung von einem Betriebsmodus in einen Programmiermodus bewirkt, und daß eine Eingabe von Signalen zur Programmierung über Eingabe-Elemente erfolgt, die an sich für Eingaben während des Betriebsmodus vorgesehen sind.

Die Erfindung ist bei digitalen Steuergeräten, welche ohnehin eine Diagnoseschnittstelle aufweisen, besonders vorteilhaft anzuwenden. Es entsteht keinerlei zusätzlicher Aufwand bezüglich des Steuergerätes selbst (Hardware). Es ist lediglich ein entsprechendes Programm im digitalen Steuergerät vorzusehen.

Eine Weiterbildung der Erfindung sieht vor, daß das Signal darin besteht, daß die Diagnoseschnittstelle für eine bestimmte Mindestzeit mit Massepotential verbunden wird. Hiermit kann ohne einen besonderen Signalgeber das zum Umschalten erforderliche Signal dem digitalen Steuergerät zugeführt werden.

Eine andere Weiterbildung des erfindungsgemäßen Verfahrens sieht vor, daß die Umschaltung von dem Betriebsmodus in den Programmiermodus nur dann möglich ist, wenn eine für den Betriebsmodus erforderliche Eingangsgröße einen vorgegebenen Wert bzw. Wertebereich aufweist.

Hierdurch wird eine zusätzliche Sicherheit gegeben, daß keine unbeabsichtigte Umschaltung in den Programmiermodus erfolgt, wenn eine Funktion des Steuergerätes unbedingt erforderlich ist. Dieses kann in einfacher Weise dadurch verwirklicht werden, daß das digitale Steuergerät ein Geschwindigkeitsregler oder Drehzahlregler ist und daß eine Umschaltung von dem Betriebsmodus in den Programmiermodus nur bei Stillstand des Fahrzeugs möglich ist.

Eine andere Weiterbildung der Erfindung besteht darin, daß Anzeigevorrichtungen, die an sich für Anzeigen während des Betriebsmodus vorgesehen sind, Informationen während des Programmiermodus ausgeben. Damit kann der Person, welche die Programmierung des digitalen Steuergerätes durchführt, eine wesentliche Hilfe gegeben werden.

Eine vorteilhafte Ausgestaltung des erfindungsgemäßen Verfahrens sieht vor, daß durch die Programmierung Datensätze ausgewählt werden, welche verschiedene zur Steuerung bzw. Regelung verwendete Kennlinien darstellen.

Eine vorteilhafte Anordnung zur Durchführung des erfindungsgemäßen Verfahrens besteht darin, daß das digitale Steuergerät mit einem Programm versehen ist, das die Diagnoseschnittstelle abfragt und bei einem vorgegebenen Signal an der Diagnoseschnittstelle den Ablauf eines Programms zur Programmierung einleitet.

Die Erfindung läßt zahlreiche Ausführungsformen zu. Eine davon ist schematisch in der Zeichnung an Hand mehrerer Figuren dargestellt und nachfolgend beschrieben. Es zeigt:

Fig. 1 eine schematische Darstellung eines digitalen Steuergerätes für ein Kraftfahrzeug und

Fig. 2 ein Flußdiagramm derjenigen Teile des Programms für das digitale Steuergerät, deren Erläuterung zum Verständnis der Erfindung erforderlich ist.

Das Steuergerät 1 umfaßt in an sich bekannter Weise einen Mikroprozessor 2 mit entsprechenden Speichern 3, 4 für Programme und Daten sowie verschiedene Ein- und Ausgänge. Das Steuergerät 1 dient als Geschwindigkeitsregler. Entsprechend ist im Nur-Lese-Speicher 3 ein Programm zur Regelung der Fahrzeuggeschwindigkeit abgelegt.

Von den Baugruppen des Mikroprozessors 2 sind lediglich solche dargestellt, welche zur Erläuterung der vorliegenden Erfindung erforderlich sind. An einen internen Datenbus 5 ist ein externer Datenbus 6 angeschlossen, der den Mikroprozessor 2 mit einem Nur-Lese-Speicher 3 und mit einem elektrisch löschbaren Nur-Lese-Speicher 4 verbindet. Letzterer ist erforderlich, um Daten, die bei der Programmierung des Steuergerätes 1 entstehen, dauerhaft abzulegen, so daß sie auch bei abgeschalteter Betriebsspannung erhaltenbleiben.

An den internen Datenbus 5 ist ein Datensender 7 angeschlossen, der über eine Ausgangsschaltung 8 mit der Schnittstelle 9 verbunden ist. Ankommende Signale werden über eine Eingangsschaltung 10 und einen Datenempfänger 11 dem internen Datenbus 5 zugeführt.

Einem Eingang 12 wird ein der Ist-Geschwindigkeit V entsprechendes Signal zugeführt. Bei dem dargestellten Ausführungsbeispiel liegt dieses Signal als pulsbreitenmoduliertes Signal vor und wird in einer Eingangsschaltung 13 in ein Analogsignal umgewandelt, das wiederum in dem A/D-Wandler 14 digitalisiert wird.

Ein weiterer Eingang 15 ist für die Motordrehzahl vorgesehen, welche als Pulssignal mit einer der Motordrehzahl proportionalen Frequenz vorliegt. Über eine Eingangsschaltung 16 wird dieses Signal einem Timer 17 zugeführt, welcher der Drehzahl entsprechende digitale Werte an den internen Datenbus 5 abgibt.

Über weitere Eingänge 18, 19 können Schaltsignale, welche mit Hilfe der Drucktasten 20, 21 erzeugt werden, über Eingangsschaltungen 22, 23 dem Mikroprozessor zugeführt werden. Schließlich ist an den internen Datenbus 5 noch ein Pulsbreitenmodulator 24 angeschlossen, welcher zur Ansteuerung eines Stellgliedes an den Ausgängen 25, 26 zueinander invertierte pulsbreitenmodulierte Signale abgibt.

Über Ausgangsschaltungen 27, 28 sind je eine Lampe 29, 30 an das Steuergerät 1 angeschlossen.

Das der Ist-Geschwindigkeit V entsprechende Signal wird mit einem vorgegebenen, im Regler gespeicherten Sollwert verglichen. Über den Ausgang 26, 27 wird ein Stellglied für die Motorleistung gesteuert. Zusätzlich zu der Geschwindigkeit V wird die Motordrehzahl n dem Steuergerät 1 zugeführt, wodurch beispielsweise eine Begrenzung der Motordrehzahl n möglich wird, wenn bei einem niedrigeren Gang eine zu hohe Soll-Geschwindigkeit gewünscht wird. Die Bedienung des Steuergerätes 1 erfolgt über die Drucktasten 20, 21. Bei der Betätigung der Drucktaste 20 wird die zu diesem Zeitpunkt vorhandene Fahrzeuggeschwindigkeit als Sollwert gespeichert. Durch Betätigung der Drucktaste 21 wird das Steuergerät abgeschaltet. Die Lampen 29, 30 dienen zur Anzeige einer Störung und zur Anzeige einer über einem Grenzwert liegenden Geschwindigkeit.

Die bidirektionale Schnittstelle 9 dient bei bekannten Steuergeräten zur Diagnose, d. h. Prüfung und Lokalisierung von Fehlern. Eine solche Schnittstelle ist durch den Normungsvorschlag ISO/DIS 9141 festgelegt und beschrieben und braucht daher zur Erläuterung der vorliegenden Erfindung nicht weiter beschrieben zu werden.

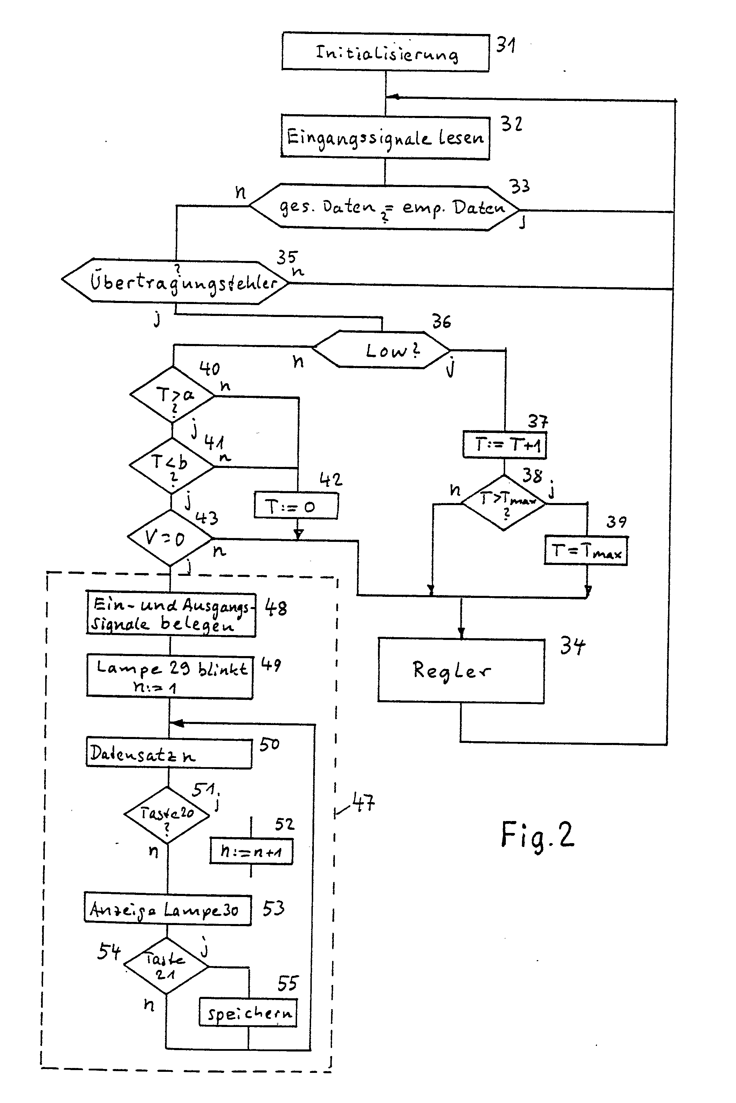

Durch ein im Zusammenhang mit Fig. 2 noch beschriebenes Programm ist das zur Durchführung des Verfahrens vorbereitete Steuergerät in der Lage zu erkennen, wenn ein Signal von mindestens 2,5 s Dauer an der Schnittstelle 9 anliegt. Ist dieses der Fall, so wird das Programm im Steuergerät 1 von dem bisher beschriebenen Betriebsmodus auf einen Programmiermodus umgeschaltet.

Um eine unbeabsichtigte Umschaltung in den Programmiermodus - beispielsweise durch einen Kurzschluß - zu verhindern, während der Regler 1 wichtige Funktionen wahrnimmt, ist an das Umschalten eine zusätzliche Bedingung geknüpft; und zwar ist eine Umschaltung nur möglich, wenn über den Eingang 12 eine Fahrzeuggeschwindigkeit von 0 km/h mitgeteilt wird. Die Programmierung als solche wird im folgenden anhand des in Fig. 2 dargestellten Flußdiagramms erläutert: Bei der Inbetriebnahme des Reglers erfolgt zunächst eine Initialisierung 31. Daraufhin werden bei 32 die Eingangssignale eingelesen, d. h. die Werte der Signaleingänge 12, 15 abgefragt.

Bei einer nach dem Normvorschlag ISO/DIS 9141 möglichen Betriebsart werden über die Schnittstelle 9 laufend Daten ausgegeben. Diese Betriebsart wird bei dem in Fig. 2 dargestellten Flußdiagramm vorausgesetzt. Bei 33 erfolgt eine Verzweigung des Programms in Abhängigkeit davon, ob die empfangenen Daten den gesendeten entsprechen. Ist dieses der Fall, so wird das Programm mit dem als Regler bezeichneten Programmteil 34 fortgesetzt. Unter anderem werden die Eingangssignale entsprechend dem gespeicherten Programm verarbeitet, die Stellgröße ermittelt und über den Ausgang 25, 26 ausgegeben. Danach werden bei 32 wieder neue Eingangssignale eingelesen.

Entsprechen die von der Schnittstelle 9 gelesenen Daten nicht den gesendeten, so wird das Programm bei 35 fortgesetzt, wo entschieden wird, ob ein Übertragungsfehler auf der bidirektionellen Diagnoseschnittstelle erkannt worden ist. Ist dieses nicht der Fall, so wird ebenfalls das Reglerprogramm 34 aufgerufen. Stellt sich jedoch bei 35 heraus, daß ein Übertragungsfehler vorliegen könnte, so wird abgefragt, ob die Schnittstelle 9 auf dem Wert Low liegt. Ist dieses der Fall, so wird eine als Timer dienende Zählvariable T bei 37 um eins inkrementiert. Mit Hilfe der Verzweigung 38 und der Wertezuordnung 39 wird der Wertebereich für T begrenzt.

Bei dem auf das Ende des Low-Signals folgenden Programmdurchlauf wird bei 36 in Richtung auf den Programmteil 40 verzweigt. Bei 40, 41 wird festgestellt, ob T innerhalb eines Bereiches liegt, der für das Signal vorgesehen ist, mit dem der Programmiermodus aktiviert werden soll. Liegt T nicht innerhalb dieses Bereiches, so wird T bei 42 zu 0 gesetzt und das Programm bei 34 fortgesetzt.

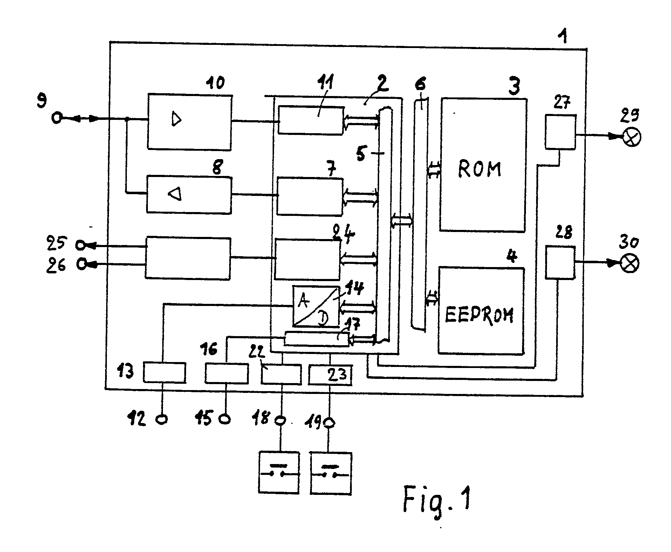

Liegt jedoch T innerhalb dieses Bereiches, so wird bei 43 geprüft, ob die Fahrzeuggeschwindigkeit V = 0 ist. Nur wenn dieses zutrifft, wird ein für den Programmiermodus vorgesehenes Programm 47 eingeleitet, das in Fig. 2 gestrichelt umrandet ist. Dazu werden bei 48 zunächst die Ein- und Ausgangssignale für die Programmierung belegt. Daraufhin wird bei 49 ein Blinken der Leuchtdiode 29 (Fig. 1) veranlaßt und eine Variable n, welche den jeweils zu programmierenden Datensatz kennzeichnet, auf eins gesetzt. Im Programmteil 50 wird der entsprechende Datensatz ausgewählt und im Programmteil 51 das Programm in Abhängigkeit vom Drücken der Taste 20 verzweigt. Ist die Taste gedrückt worden, so wird bei 52 n inkrementiert, so daß der nächste Datensatz angewählt wird. Ist die Taste nicht gedrückt worden, so bleibt n.

Bei 53 wird eine Anzeige über die Lampe 30 veranlaßt, welcher Datensatz angewählt ist. Zur Unterscheidung kann die Lampe mit verschiedenen Frequenzen bzw. auch kontinuierlich aufleuchten. Daraufhin wird bei 54 bei gedrückter Drucktaste 21 der Programmteil 55 zur Speicherung des Datensatzes im Speicher 4 (Fig. 1) gestartet. Falls die Drucktaste 21 nicht gedrückt worden ist, wird das Programm bei 50 fortgesetzt, so daß gegebenenfalls ein weiterer Datensatz angewählt und gespeichert werden kann. Die zu speichernden Daten- sätze können beispielsweise eine Höchstge- schwindigkeit oder eine Zuordnung der Frequenz der bei 15 (Fig. 1) zugeführten Drehzahlimpulse zu der Motordrehzahl darstellen. Ein Verlassen des Programmiermodus kann in einfacher Weise durch Abschalten des Steuergerätes bewirkt werden.

## Ansprüche

1. Verfahren zur Programmierung eines für ein Kraftfahrzeug vorgesehenen digitalen Steuergerätes, welches mit einer Diagnoseschnittstelle versehen ist, dadurch gekennzeichnet, daß der Diagnoseschnittstelle ein Signal zugeführt wird, welches eine Umschaltung von einem Betriebsmodus in einen Programmiermodus bewirkt, und daß eine Eingabe von Signalen zur Programmierung über Eingabe-Elemente erfolgt, die an sich für Eingaben während des Betriebsmodus vorgesehen sind.

2. Verfahren nach Anspruch 1, dadurch gekennzeichnet, daß das Signal darin besteht, daß die Diagnoseschnittstelle für mindestens 2,5 s mit Massepotential verbunden wird.

3. Verfahren nach einem der Ansprüche 1 oder 2, dadurch gekennzeichnet, daß die Umschaltung von dem Betriebsmodus in den Programmiermodus nur dann möglich ist, wenn eine für den Betriebsmodus erforderliche Eingangsgröße einen vorgegebenen Wert bzw. Wertebereich aufweist.

4. Verfahren nach Anspruch 3, dadurch gekennzeichnet, daß das digitale Steuergerät ein Geschwindigkeitsregler ist und daß eine Umschaltung von dem Betriebsmodus in den Programmiermodus nur bei Stillstand des Fahrzeugs möglich ist.

5. Verfahren nach einem der vorhergehenden Ansprüche, dadurch gekennzeichnet, daß Anzeigevorrichtungen, die an sich für Anzeigen während des Betriebsmodus vorgesehen sind, Informationen während des Programmiermodus ausgeben.

6. Verfahren nach einem der vorhergehenden Ansprüche, dadurch gekennzeichnet, daß durch die Programmierung Datensätze ausgewählt werden, welche verschiedene zur Steuerung bzw. Regelung verwendete Kennlinien darstellen.

7. Anordnung zur Durchführung des Verfahrens nach einem der vorhergehenden Ansprüche, dadurch gekennzeichnet, daß das digitale Steuergerät mit einem Programm versehen ist, das die Diagnoseschnittstelle abfragt und bei einem vorgegebenen Signal an der Diagnoseschnittstelle den Ablauf eines Programms zur Programmierung ein- leitet.

Fig. 1

0 292 644

Fig. 2

| Europäisches Patentamt | EUROPÄISCHER RECHERCHENBERICHT | Nummer der Anmeldung |
|---|---|---|
| | | EP 88 10 2357 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-3 233 833 (SWF-SPEZIALFABRIK FÜR AUTOZUBEHÖR GUSTAV RAU GMBH) * ganzes Dokument * --- | 1,6,5 | B 60 K 31/04 G 06 F 11/22 G 01 R 31/28 |
| Y | FR-A-2 589 264 (OKI ELECTRIC INDUSTRY CO.,LTD.) * Zusammenfassung; Seite 3, Zeile 7 - Seite 5, Zeile 2; Seite 9, Zeilen 8-22; Seite 13, Zeile 20 - Seite 16, Zeile 10; Anspruch 1; Figuren 1,5,6 * --- | 1,6,5 | |
| A | US-A-4 402 217 (K. HIGASHIYAMA) * Zusammenfassung; Spalte 8, Zeilen 30-52; Ansprüche, Figuren 1-3 * --- | 1,2,7 | |
| A | EP-A-0 140 057 (R. BOSCH GMBH) * ganzes Dokument * --- | 1,2,7 | |
| A | EP-A-0 157 084 (R. BOSCH GMBH) * ganzes Dokument * --- | 1,5 | |
| A | DE-A-3 423 817 (DIEHL GMBH & CO.) * gesamtes Dokument * --- | 1,5 | RECHERCHIERTE SACHGEBIETE (Int. Cl.4) |
| A | EP-A-0 024 564 (DÜRKOPPWERKE GMBH) * Zusammenfassung; Seite 5, Zeile 1 - Seite 6, letzte Zeile; Ansprüche 1-7; Figur 1 * --- | 1,5 | G 01 M 15/00 G 05 B 23/00 G 05 B 19/00 G 01 R 31/00 G 06 F 3/00 G 06 F 11/00 |
| A | GB-A-2 068 589 (TURNRIGHT CONTROLS LTD.) * Seite 1, Zeilen 20-33; Seite 3, Zeile23 - Seite 5, Zeile 2; Seite 6, Zeilen 27-30; Ansprüche 1,2,12,16; Figuren 1,2 * ----- | 1,5 | B 60 Q 9/00 B 60 K 31/00 G 07 C 5/00 |

Der vorliegende Recherchenbericht wurde für alle Patentansprüche erstellt

| Recherchenort | Abschlußdatum der Recherche | Prüfer |
|---|---|---|
| BERLIN | 24-08-1988 | BEITNER M.J.J.B. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.......................................................................
& : Mitglied der gleichen Patentfamilie, übereinstimmendes Dokument

EPO FORM 1503 03.82 (P0403)